Europäisches Patentamt

European Patent Office

Office européen des brevets

(11) Publication number: **0 256 756**
**A2**

(12) **EUROPEAN PATENT APPLICATION**

(21) Application number: 87306902.5

(22) Date of filing: 04.08.87

(51) Int. Cl.⁴: **H01B 5/16** , H01R 4/04

(30) Priority: 05.08.86 JP 183928/86

(43) Date of publication of application:
24.02.88 Bulletin 88/08

(84) Designated Contracting States:
DE FR GB IT

(71) Applicant: **MINNESOTA MINING AND MANUFACTURING COMPANY**
**3M Center, P.O. Box 33427**
**St. Paul, Minnesota 55133-3427(US)**

(72) Inventor: **Tanaka, Kenji c/o Minnesota Mining and**
**Manufacturing Company 2501 Hudson Road**
**P.O. Box 33427 St. Paul Minnesota 55133(US)**
Inventor: **Saito, Tsutomu c/o Minnesota Mining and**
**Manufacturing Company 2501 Hudson Road**
**P.O. Box 33427 St. Paul Minnesota 55133(US)**
Inventor: **Tanaka, Kiyotaka c/o Minnesota Mining and**
**Manufacturing Company 2501 Hudson Road**
**P.O. Box 33427 St. Paul Minnesota 55133(US)**
Inventor: **Shizukuda, Haruo c/o Minnesota Mining and**
**Manufacturing Company 2501 Hudson Road**
**P.O. Box 33427 St. Paul Minnesota 55133(US)**

(74) Representative: **Baillie, Iain Cameron et al**
**c/o Ladas & Parry Isartorplatz 5**
**D-8000 München 2(DE)**

(54) **Electrically conductive tape.**

(57) An electrically conductive tape comprising an electrically conductive porous backing material having an electrically conductive adhesive coated on one or both sides of the backing.

EP 0 256 756 A2

## ELECTRICALLY CONDUCTIVE TAPE

Technical Field

The invention relates to an electrically conductive tape which is conductive through the thickness thereof and displays high flexibility

Background of the Invention

One electrically conductive tape known in the industry comprises an embossed metallic foil having an adhesive system applied on one surface thereof. In addition, a second tape comprises an adhesive system comprising metallic particles therein, same being applied on a surface of a metallic foil.

Such known electrically conductive tapes, however, are typically devoid of flexibility through the use of a foil-like metallic substrate such as metal foil. In such a system, if the terminal to be connected by the tape is rigid or has dirt or dust on the surface thereof, failure to provide a tight attachment thereto can occur, and thus cause improper electrical connection unless the pressure of application of the tape is significantly increased.

Also, since such tapes typically contain an adhesive system on only one surface of the substrate, such cannot be utilized for electrical connection between the faces of electrically conductive materials. Double-sided electrically conductive adhesive tapes can be manufactured by application of an adhesive system on both sides of the conductive substrate, but in actuality, when a conventional substrate such as metallic foil is utilized, it is difficult to provide stable electrical conduction due to the lack of flexibility of such substrates.

In the second adhesive tape discussed above, a pair of electrically conductive contacts can be connected by placing therebetween an adhesive film in which metallic particles have been dispersed, but in such case difficulties were encountered because of the lack of dimensional stability of the adhesive film. Furthermore, although electrical conductivity can be provided in such a system relatively easy through the thickness thereof, it has been necessary to disperse the conductive particles in a high volume content, e.g., such as 60% by volume or more, in order to render the film sufficiently conductive in the length or width direction thereof. Such high content of conductive particles in the adhesive film contributes to the reduced adhesive strength thereof.

Accordingly, the present invention provides an electrically conductive tape which is free from the defects discussed above, which has electrical conductivity in all directions, e.g., length, width and thickness, and is further characterized by a stable electrical conductivity and high flexibility.

Summary of the Invention

In accordance with the invention, there is provided an electrically conductive tape comprising a flexible and electrically conductive porous substrate having an electrically conductive adhesive system applied on at least one side thereof.

Description of the Drawing

Figure 1 illustrates an example of an electrically conductive tape in accordance with the invention, wherein Figure 1(a) is a sectional view and (b) is a plane view;

Figure 2 is a sectional illustration of a second example of an electrically conductive tape of the invention, wherein Figure 1(a) illustrates a tape having an adhesive system coated on both sides of a substrate, and (b) illustrates a tape having the adhesive tape coated on one side;

Figure 3 is a sectional illustration of yet another example of an electrically conductive tape of the invention, wherein Figure 1(a) illustrates a tape having an adhesive system coated on one side and (b) illustrates a tape having adhesive coated on both sides of the substrate.

Detailed Description of the Invention

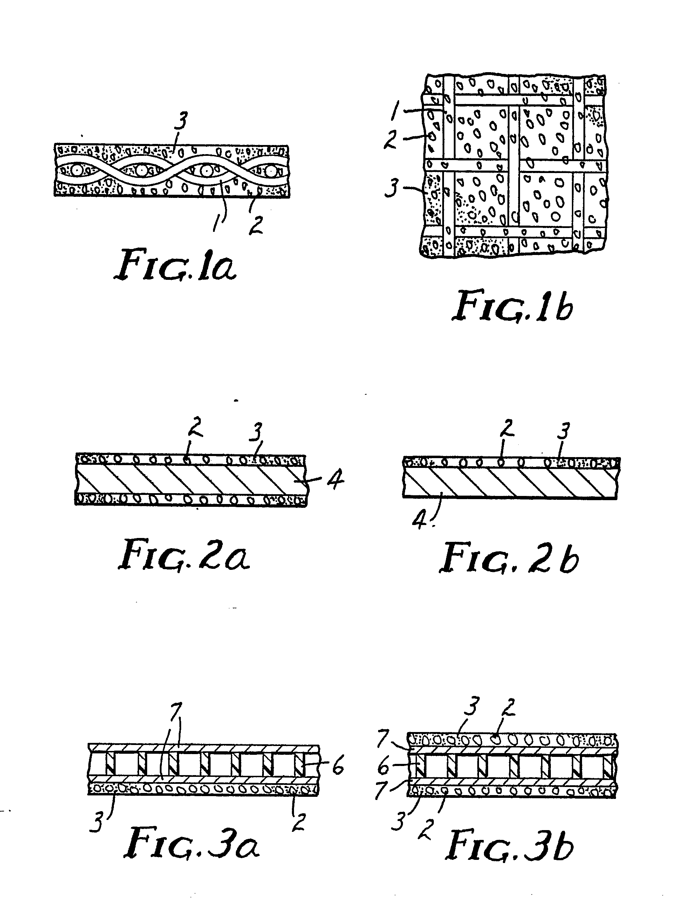

Figure 1 illustrates an electrically conductive tape comprising metal-plated netted woven material 1 coated on both sides with adhesive 3 containing conductive metallic powder 2 therein.

Figure 2 illustrates another embodiment wherein porous substrate 4 is an electrically conductive non-woven fabric coated on both sides (Figure 2(a)) or one side (Figure 2(b)) with adhesive 3 containing metal particles 2 therein.

Figure 3 utilizes porous film 6 having a conductive coating 7 thereon, with adhesive 3 containing conductive particles 2 therein one one side (Figure 3(a)) or both sides (Figure 3(b)).

Various types of substrate materials having sufficient flexibility can be utilized as the porous substrate of the invention. Examples thereof include reticulate substrates utilizing metallic fibers, synthetic fibers or natural fibers, non-woven sheets, and porous organic films. A reticulate or non-woven sheet-like substrate using metallic fibers tends to suffer from problems such as breakage after bending, and thus it is preferred to use either synthetic or natural fibers.

Relative to synthetic or natural fibers, or organic films for the porous substrate, same can be subjected to various treatments for making same electrically conductive. Treatments such as metal plating, vacuum deposition, sputtering, coating, etc. are all available to render the substrate electrically conductive.

The conductive adhesive system used in the invention can be prepared by dispersing electrically conductive particles in an adhesive resin matrix. As the conductive particles, examples include nickel, iron, chromium, cobalt, aluminum, antimony, molybdenum, copper, silver, platinum, gold and their alloys are all examples. Furthermore, mixtures of such particles can be utilized. Where particles which are not inherently electrically conductive are desired, such as, for example, particles of glass or plastic, same can also be utilized by first coating them with such conductive metals.

For the adhesive system, materials having tackiness at or around room temperature, i.e., pressure-sensitive adhesives, and thermoplastic materials which manifest their adhesion upon heating, i.e., heat sensitive adhesives, are exemplary. Such materials which are capable of heat curing are similarly usable in the invention.

Examples of pressure-sensitive adhesives include those based on acrylic ester rubber, natural rubber, silicone rubber, polychloroprene, butadiene-styrene copolymers, ethylene-vinyl acetate copolymers, polyisobutylene, polyvinyl ether rubber and the like.

Exemplary thermoplastic adhesives useful in the invention include those based on ethylene-vinyl acetate copolymers, polyethylene, ethylene-propylene copolymer, ethylene-acrylic ester copolymer, acrylic ester rubber, polyisobutylene, polyvinyl butyral, styrene-butadiene copolymer, polybutadiene, ethylene cellulose, polyamide, polyester, polyurethane, and the like.

Conventionally, other additives, such as tackifiers, plasticizers, crosslinking agents, anti-aging agents, antioxidants, etc., can be utilized to provide particular characteristics to the adhesive matrix regardless of the type of adhesive utilized. For example, as tackifiers, rosins, hydrogenated rosins, rosin esters, maleic acid, modified rosins and other rosin resins, petroleum resins, xylene resins, cumarone-indene resins, etc., are exemplary.

The invention will now be illustrated through the use of the following non-limiting examples.

Example 1

A 150 micrometer thick polyester fabric was plated with nickel (No. Ni-10-33, commercially available from Seren K.K.). A pressure-sensitive acrylic adhesive (Arocet No. 8025, commercially available from Nippon Shokubai Kagaku Kogyo KK) was mixed with 20% by weight of nickel powder (carbonyl nickel No. 287, commercially available from Inco Co., Ltd. having an average particle size of 30 micrometers). This adhesive system was applied to both sides of the nickel-plated polyester fabric to a coating thickness of 20 micrometers to thus obtain a double-sided adhesive-coated electrically conductive tape.

This tape was applied to a 10 cm × 10 cm × 3 mm thick copper plate, and then a 25 mm × 25 mm copper foil was attached over the second adhesive surface. The resistivity between the copper plate and the upper surface of the copper foil was measured utilizing a milliohmmeter, with the resistance being $10 \times 10^{-2}$ ohms.

Example 2

Copper particles (FC-115, commercially available from Fukuda Kinzokuhaku Kogyo KK) having an average particle size of 30 micrometers were dispersed in a commercially available adhesive (SK Dyne -1700, commercially available from Soken Kagaku KK) such that the adhesive contained 20% by weight of copper particles. This adhesive system was applied to one side of an 0.05 millimeter aluminized nonwoven fabric to a coating thickness of 20 micrometers to thus obtain an electrically conductive tape of the type illustrated in Figure 2(b).

Two copper plates each of 10 cm $\times$ 10 cm $\times$ 3 cm thick were connected through the electrically conductive tape of this Example, maintaining a distance of 5 centimeters between the plates. The resistivity between the two copper plates was found to be $10 \times 10^{-3}$ ohms.

Example 3

A 10 millimicrometer thick polycarbonate film was perforated to provide pores of 0.3 micrometer diameter therein, followed by coating with an electrically conductive commercially available material (Syntron 4421, commercially available from Shinto Toryo KK) to a thickness of 5 micrometers. The conductive adhesive system of Example 2 was then applied to one side of the conductive flexible film to provide an electrically conductive tape of the structure illustrated in Figure 3(a).

The contact resistivity of this tape as measured by the method detailed in Example 1, was $1 \times 10^{-4}$ ohms.

Example 4

An electrically conductive double-sided adhesive tape having a structure as illustrated in Figure 2 was obtained by utilizing a 300 mesh wire gauge consisting of 30 micrometer diameter copper wires, followed by adhesive application pursuant the procedure of Example 1. The contact resistivity was determined to be $1 \times 10^{-4}$ ohms.

Example 5

An electrically conductive tape of the structure illustrated in Figure 2(b) was obtained by following the procedure set out in Example 2 with the exception of utilizing a polyester hot melt adhesive (R-251, commercially available from Toray Ltd.) in place of the acrylic adhesive utilized therein. Two copper plates were contacted in the same fashion as Example 2 utilizing this adhesive, the connecting operation being undertaken at 150°C and a pressure of 20 kg/cm² for a time period of 30 seconds. The contact resistivity was determined to be $5 \times 10^{-3}$ ohms.

Example 6 and Comparative Example

A conventional electrically conductive tape was prepared by applying the adhesive system of Example 1 onto a 80 micrometer thick copper foil to a coating thickness of 20 micrometers. This tape is labeled Tape A in Table 1.

An electrically conductive tape of the invention was prepared by applying the same adhesive on one side of a copper-plated mesh fabric (No. Ni-10-33, commercially available from Seren KK.) to a coating thickness of 20 micrometers, with this tape being designated Tape B in Table 1.

Two copper plates were connected utilizing these tapes in the same manner detailed in Example 2, with initial resistivity and resistivity after the passage of time being recorded. The results are tabulated in Table 1.

## Table 1

### Resistivity Ω

| Tape | Initial | After passage of 168 hours under 80°C and 95% RH |
|------|---------|--------------------------------------------------|
| A | $1 \times 10^{-2}$ | $5 \times 10^{-1}$ |
| B | $5 \times 10^{-3}$ | $1 \times 10^{-2}$ |

Example 7

An approximately 35 millimicrometer thick polyimide film was perforated with a metal needle to form pores therein of approximately 100 micrometers in size at a rate of 9 pores/cm², following which nickel was vacuum deposited on both sides thereof to a thickness of approximately 1000 angstroms. The adhesive system of Example 1 was then applied to both sides of this flexible film to produce an electrically conductive double-sided tape. A copper foil was adhered to a copper plate using this tape, with the resistivity between the plate and foil being $1 \times 10^{-3}$ ohms.

As hereinabove described, the electrically conductive tape of this invention utilizes a flexible woven fabric, nonwoven fabric or porous film as the substrate thereof to provide high flexibility in its entirety as compared with conventional electrically conductive tapes using metal foil, etc., as the substrate. Therefore, the tape of this invention can be tightly attached to conductive terminals with no necessity for increased attaching pressure, even if the terminals are rigid or have dirt or dust on the surface thereof, and there is no fear of causing an improper connection therebetween.

Therefore, the electrically conductive tape of the invention can find effective use as an electrically conductive gasket, a ground lead, etc.

Further, there can be obtained an electrically conductive double-sided adhesive tape which has good dimensional stability or form retention, is easy to handle, and is capable of providing stable conductivity for electrical connections.

**Claims**

1. An electrically conductive tape comprising a flexible electrically conductive porous substrate having an electrically conductive adhesive system applied on at least one surface thereof.

2. The tape of claim 1 wherein said substrate comprises a reticulate material.

3. The tape of claim 2 wherein said reticulate material comprises metallic fibers.

4. The tape of claim 2 wherein said reticulate material comprises synthetic fibers having an electrically conductive coating thereon.

5. The tape of claim 2 wherein said reticulate material comprises a natural fiber having an electrically conductive coating thereon.

6. The tape of claim 2 wherein said reticulate material comprises a nonwoven web containing an electrically conductive coating thereon.

7. The tape of claim 1 wherein said adhesive system comprises a pressure-sensitive adhesive containing an effective amount of electrically conductive particles therein.

8. The tape of claim 1 wherein said adhesive system comprises a thermoplastic adhesive containing an effective amount of electrically conductive particles therein.

FIG. 1a

FIG. 1b

FIG. 2a

FIG. 2b

FIG. 3a

FIG. 3b